Europäisches Patentamt

**European Patent Office**

**Office européen des brevets**

(19)

(11) Numéro de publication: **0 271 936 B1**

(12) **FASCICULE DE BREVET EUROPEEN**

(45) Date de publication de fascicule du brevet: **30.09.92**

(51) Int. Cl.5: **H03M 1/18**, H04N 5/20, H03G 3/20

(21) Numéro de dépôt: **87202161.3**

(22) Date de dépôt: **06.11.87**

(54) **Dispositif de conversion analogique-numérique comportant un dispositif de contrôle automatique de gain.**

(30) Priorité: **14.11.86 FR 8615854**

(43) Date de publication de la demande:
**22.06.88 Bulletin 88/25**

(45) Mention de la délivrance du brevet:
**30.09.92 Bulletin 92/40**

(84) Etats contractants désignés:
**DE FR GB IT**

(56) Documents cités:
**FR-A- 2 378 401       FR-A- 2 406 922
FR-A- 2 536 620       GB-A- 2 115 629
US-A- 3 614 436       US-A- 3 770 984**

**PATENT ABSTRACTS OF JAPAN, Vol.9, Nr. 216 (E-340)[1939], 3 Septembre 1985; & JP-A-60 75 112**

(73) Titulaire: **PHILIPS COMPOSANTS
117, quai du Président Roosevelt
F-92130 Issy les Moulineaux(FR)**

(84) Etats contractants désignés:
**FR**

(73) Titulaire: **N.V. Philips' Gloeilampenfabrieken
Groenewoudseweg 1
NL-5621 BA Eindhoven(NL)**

(84) Etats contractants désignés:
**DE GB IT**

(72) Inventeur: **Baars, Nicolaas Société Civile
S.P.I.D.
209, rue de l'Université
F-75007 Paris(FR)**
Inventeur: **Ducrot, Etienne Société Civile
S.P.I.D.
209, rue de l'Université
F-75007 Paris(FR)**

(74) Mandataire: **Charpail, François et al
Société Civile S.P.I.D. 156, Boulevard Haussmann
F-75008 Paris(FR)**

# Description

La présente invention a pour objet un dispositif de conversion analogique-numérique comportant un dispositif de contrôle automatique de gain comprenant un amplificateur analogique à gain commandable disposé en amont d'un convertisseur analogique-numérique, et une boucle de commande du gain dudit amplificateur analogique recevant des signaux de sortie du convertisseur et comportant des moyens de comparaison pour comparer par tout ou rien le niveau de sortie du convertisseur analogique-numérique avec au moins un seuil donné et consistant en au moins un décodeur numérique de niveau de sortie ainsi que des moyens pour agir de manière temporisée sur le gain de l'amplificateur en fonction du résultat de ladite comparaison .

Un tel convertisseur analogique-numérique est connu de la demande de brevet britannique GB 2115629 (RCA Corp.). Dans celle-ci, la valeur des échantillons numériques du convertisseur est comparée numériquement avec un niveau de référence, de manière à produire un signal numérique de différence qui est converti par un convertisseur numérique-analogique en un signal analogique de réglage de gain de l'amplificateur à gain commandable. Cette solution conduit à un circuit compliqué et donc coûteux.

La présente invention a pour objet un dispositif de conversion analogique-numérique du type précité, dans lequel on n'utilise pas de convertisseur numérique-analogique pour commander le gain de l'amplificateur. De ce fait, le dispositif de conversion est simplifié et donc moins coûteux.

Le dispositif de conversion selon l'invention est dans ce but caractérisé en ce que les moyens de temporisation consistent en une première source de courant commandable agissant sur la charge et la décharge d'un premier condensateur connecté à l'entrée de commande de gain dudit amplificateur, la première source de courant étant commandée par la sortie des moyens de comparaison.

Un tel décodeur numérique est avantageusement agencé pour décoder au moins un niveau logique correspondant à au moins un niveau de blanc d'une émission de télévision.

Pour fonctionner selon plusieurs standards, notamment en télévision, le dispositif comporte avantageusement une pluralité de décodeurs numériques de niveau de sortie sélectionnés en fonction du niveau de sortie numérique désiré.

Ladite source de courant commandable peut comporter un premier étage différentiel présentant un premier et un deuxième transistors dont les émetteurs sont couplés et connectés à une première source de courant de commande, le collecteur du premier transistor étant connecté à une source de tension d'alimentation et celui du deuxième transistor audit premier condensateur ainsi qu'à une deuxième source de courant de commande, la base des premier et deuxième transistors recevant un premier signal différentiel correspondant au résultat de ladite comparaison, la deuxième source de courant ayant une valeur de courant nettement supérieure à celle de la première source de courant, de telle sorte que le premier condensateur se charge avec une constante de temps donnée à travers la deuxième source de courant pour un premier état logique du premier signal différentiel et pour un deuxième état logique dudit signal se décharge avec une constante de temps plus courte à travers la première source de courant.

Le dispositif selon l'invention peut comporter également des moyens pour agir de manière temporisée sur le niveau continu à l'entrée de l'amplificateur en fonction du résultat d'une comparaison formée par au moins un décodeur de niveau continu. Lesdits moyens pour agir de manière temporisée sur le niveau continu peuvent alors consister en une deuxième source de courant commandable agissant sur la charge et la décharge d'un deuxième condensateur connecté en série à l'entrée dudit amplificateur. La sortie du décodeur de niveau continu commande avantageusement la deuxième source de courant.

Selon un mode de réalisation préféré ladite source de courant commandable comporte un deuxième étage différentiel présentant un troisième et un quatrième transistor dont les émetteurs sont couplés et connectés à une troisième source de courant de commande, le collecteur du troisième transistor étant connecté à celui d'un cinquième transistor dont l'émetteur est connecté à ladite source de tension d'alimentation le collecteur du quatrième transistor étant connecté audit deuxième condensateur ainsi qu'au collecteur d'un sixième transistor dont l'émetteur est connecté à ladite source de tension d'alimentation, les bases des cinquième et sixième transistors étant interconnectées la base et le collecteur du cinquième transistor étant en outre court-circuités de telle sorte que les cinquième et sixième transistors forment un miroir de courant.

Le dispositif comporte avantageusement une pluralité de décodeurs de niveau continu sélectionnés en fonction du niveau continu désiré.

L'invention sera mieux comprise à la lecture de la description qui va suivre donnée à titre d'exemple non limitatif, en liaison avec les figures qui représentent :

- la figure 1, un schéma général d'un dispositif selon l'invention,
- la figure 2 un schéma d'un mode de réalisation de la logique de correction automatique de gain en TV multi-standards, et

- la figure 3, un schéma d'un mode de réalisation de la logique de correction de niveau continu en TV multi-standards,
- les figures 4 et 5, des modes de réalisation des sources de courant commandées correspondant respectivement à un contrôle automatique de gain et à une correction de niveau continu.
- les figures 6, 7a et 7b respectivement les signaux de luminance en PAL ou SECAM, un signal selon le standard MAC, et un détail du signal de luminance des dernières lignes d'une image selon le standard MAC.
- la figure 8 illustre les états logiques d'un codage en code GRAY fourni par des sorties $G_1...G_8$ du convertisseur, et la figure 9 un décodeur fonctionnant à partir de ce code,
- les figures 10 et 11 un mode de réalisation d'un circuit produisant respectivement les signaux $S_2$ et $S_1$ des figures 2 et 3 à partir des sorties du décodeur de la figure 9.

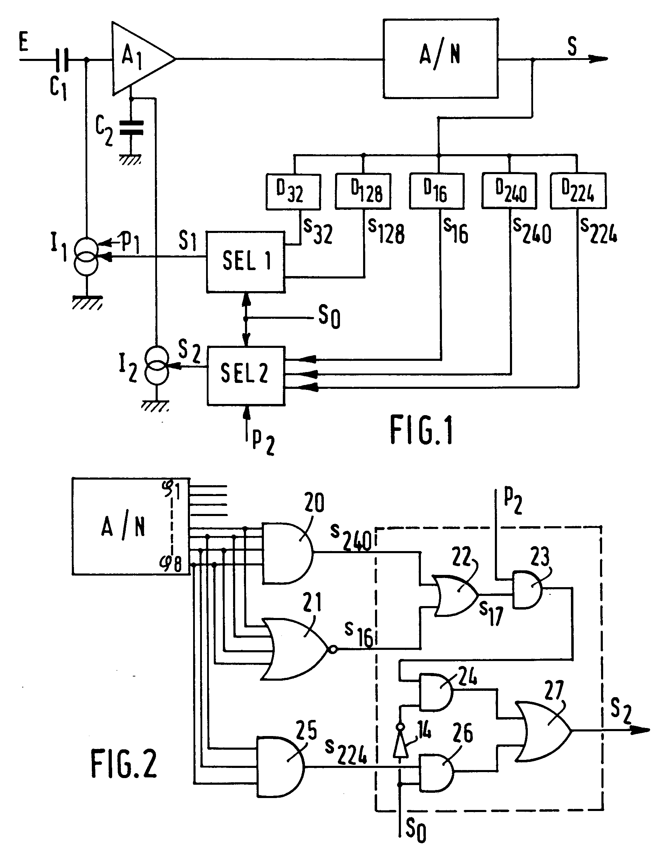

Selon la figure 1, un amplificateur $A_1$ du type à gain variable présente à son entrée de commande de gain une borne d'un condensateur $C_2$ dont l'autre borne est reliée à la masse.

La charge et la décharge des condensateurs $C_2$ est obtenue par une source de courant commandable $I_2$ qui permet de réaliser une contre-réaction de contrôle automatique de gain. La sortie de l'amplificateur $A_1$ attaque un convertisseur analogique-numérique A/N dont les sorties S fournissent un signal numérique dont le niveau est à contrôler selon certains paramètres, notamment en vue d'éviter la saturation en sortie du convertisseur. Dans le cas d'espèce, on a représenté un convertisseur analogique-numérique pour récepteur de télévision utilisable aussi bien en réception classique PAL ou SECAM qu'en réception satellite suivant les normes MAC. A cet effet, les signaux S sont introduits dans des décodeurs $D_{16}$, $D_{240}$ et $D_{224}$ dont les signaux de sorties $s_{16}$, $s_{240}$ (pour la norme MAC) et $s_{224}$ (en PAL ou SECAM) sont chacun à un niveau logique 1 ou 0 suivant l'état de la sortie S. Les signaux $s_{16}$, $s_{240}$ et $s_{224}$ sont introduits dans un circuit de sélection SEL.2 qui reçoit un signal logique de sélection $S_0$ indiquant si le récepteur fonctionne sur une émission en PAL ou SECAM, ou bien sur une émission suivant la norme MAC. Le circuit de sélection SEL2 reçoit également des impulsions de commande $p_2$ de contrôle automatique de gain.

Le signal de sortie $S_2$ du circuit de sélection SEL2 commande la source de courant $I_2$ dans un sens ou dans l'autre avec une intensité pouvant être différente selon le sens, de manière à obtenir une charge ou une décharge temporisée du condensateur $C_2$, avec des constantes de temps éventuellement différentes.

Selon l'invention, on peut également réaliser de manière analogue une correction du niveau continu en commandant la charge et la décharge temporisée d'un condensateur $C_1$ disposé en série à l'entrée de l'amplificateur $A_1$ à l'aide d'une source de courant commandable $I_1$.

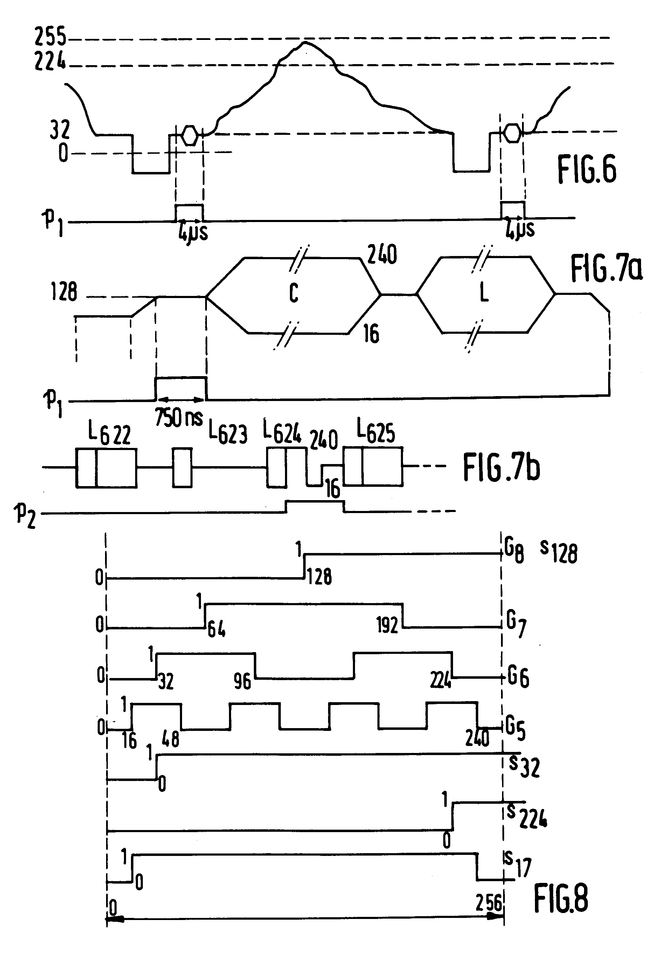

En se référant toujours à l'exemple précédent, concernant un récepteur de télévision multi-standards, les signaux de sortie S du convertisseur A/N sont introduits aux entrées de deux décodeurs $D_{32}$ et $D_{128}$ produisant en sortie des signaux $s_{32}$ (en PAL ou SECAM) et $s_{128}$ (pour la norme MAC) qui sont chacun à un niveau logique 1 ou 0 suivant l'état de la sortie S. Les signaux $s_{32}$ et $s_{128}$ sont introduits dans un circuit de sélection $SEL_1$ qui reçoit le signal logique de sélection $S_0$ idiquant si le récepteur fonctionne sur une émission en PAL ou SECAM, ou bien sur une émission suivant la norme MAC. Le circuit de sélection SEL1 reçoit également des impulsions de commande $p1$ de correction de niveau continu (voir fig. 6). Une telle impulsion est présente en PAL ou en SECAM au début de chaque ligne au moment où le signal est à un palier égal à un huitième de l'amplitude maximale (soit 32 pour un codage 8 bits). Selon le système MAC, le signal $p1$ est une impulsion de largeur 750 ns au début de chaque ligne pendant laquelle le signal est à un palier égal à la moitié de l'amplitude maximale soit 128 pour un codage 8 bits (voir fig.7a). Le signal de sortie $S_1$ du circuit de sélection SEL1 commande la source de courant $I_1$ dans un sens ou dans l'autre de manière à obtenir une charge ou une décharge temporisée du condensateur $C_1$.

En se référant à la figure 2, nous allons maintenant décrire de manière plus précise comment est généré le signal $S_2$ de contrôle automatique de gain. Selon le standard MAC, la correction a lieu sur un signal fourni à la ligne 624 de chaque image (voir fig. 7b), qui est réservée aux signaux de référence blanc, noir et gris. Le signal étant symétrique, on réalise le contrôle automatique de gain en agissant aussi bien sur le niveau du blanc que sur celui du noir. Le niveau du noir est obtenu en décodant la valeur 16 et le niveau du blanc en décodant la valeur 240. En raison de la symétrie du signal de référence de la ligne 624 (standard MAC), le contrôle automatique de gain est piloté par un signal $s_{16}$ qui a dans le cas d'espèce pour valeur 1 lorsque la sortie du convertisseur analogique-numérique a une valeur ≤15 et pour valeur 0 sinon, et par un signal $S_{240}$ qui a pour valeur 1 lorsque la sortie du convertisseur a une valeur ≥240 et 0 sinon. Le signal $s_{16}$ est le signal de sortie d'une porte ET 20 dont les quatre entrées reçoivent respectivement les quatre bits de plus fort poids en sortie du convertisseur, à savoir $Q_5$, $Q_6$, $Q_7$ et $Q_8$. Le signal $s_{16}$ est le signal de sortie d'une porte OU inverseuse 21 dont les quatre entrées reçoivent également respectivement les bits $Q_5$, $Q_6$, $Q_7$ et $Q_8$.

Les signaux $s_{16}$ et $s_{240}$ sont introduits aux deux entrées respectives d'une porte OU 22 dont le signal de sortie attaque une des deux entrées d'une porte ET 23 dont l'autre entrée reçoit les impulsions $p_2$ représentatives de la ligne 624 (voir fig. 7b). La sortie de la porte ET 23 est appliquée à une entrée d'une porte ET 24 dont l'autre entrée reçoit le signal de sélection $S_0$ inversé par l'inverseur 4.

Selon les standards PAL ou SECAM, le niveau de référence retenu pour réaliser le contrôle automatique de gain est le niveau 224 en sortie du convertisseur. Contrairement au standard MAC, le contrôle automatique de gain est réalisé ligne par ligne. Le signal $s_{224}$ est choisi de manière à avoir un niveau logique 1 pour tout niveau en sortie du convertisseur $\geq 224$, et un niveau logique 0 sinon. Pour ce faire, on applique les trois bits de plus fort poids $Q_6$, $Q_7$ et $Q_8$ respectivement aux trois entrées d'une porte ET 25, dont la sortie, qui fournit donc le signal $s_{224}$ attaque une des deux entrées d'une porte ET dont l'autre entrée reçoit le signal de sélection So. Les sorties des portes ET 24 et 26 sont appliquées respectivement aux entrées d'une porte OU 27 dont la sortie fournit le signal S2.

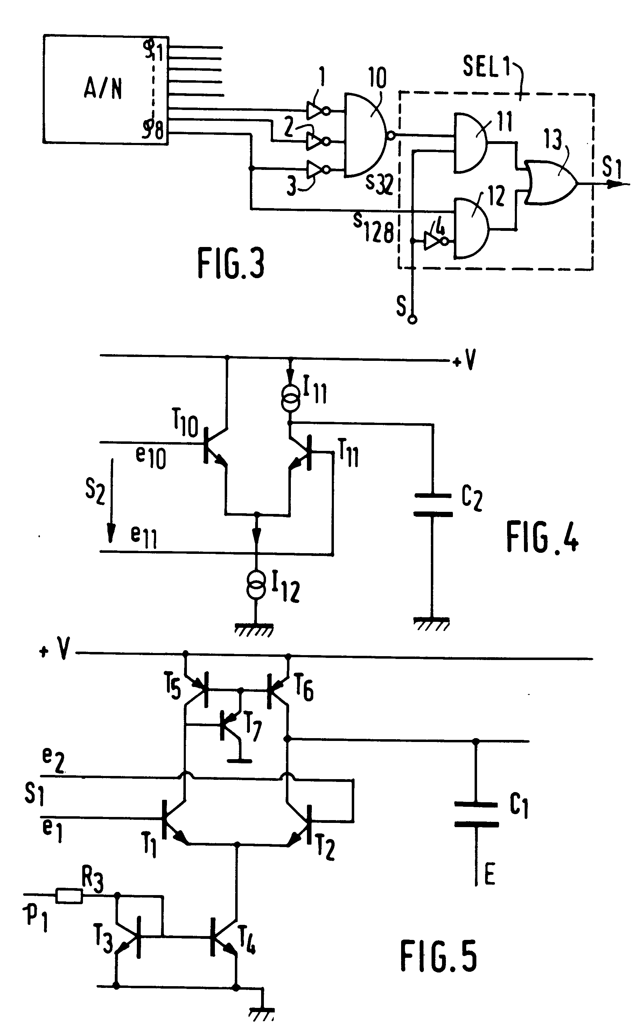

En se référant à la figure 3, nous allons maintenant décrire de manière plus précise comment est généré le signal $S_1$ de correction de niveau continu. Dans les systèmes PAL ou SECAM, le niveau du fond noir correspond à la valeur 32 en sortie d'un convertisseur analogique-numérique 8 bits. La valeur 32 est atteinte dès qu'un des trois premiers bits de poids fort $Q_6$, $Q_7$, $Q_8$ a la valeur 1. Par conséquent, la détection (décodeur $D_{32}$) du niveau du fond continu de référence est réalisée en introduisant les sorties $Q_6$, $Q_7$ et $Q_8$ aux entrées respectivement des inverseurs 1, 2 et 3 dont les sorties attaquent les trois entrées d'une porte ET inverseuse 10. De la sorte le signal de sortie $s_{32}$ est au niveau 0 lorsque $Q_6 = Q_7 = Q_8 = 0$ et au niveau 1 dans tous les autres cas, c'est-à-dire dès que le fond noir atteint la valeur numérique 32. Dans le système MAC, la correction de niveau continu ne s'effectue pas sur le fond noir, mais sur le niveau du gris qui correspond à une valeur de 128 à la sortie d'un convertisseur analogique-numérique à 8 bits. Pour le décoder (décodeur $D_{128}$), il suffit de prendre la sortie de poids fort $Q_8$ du convertisseur qui fournit donc directement le signal $s_{128}$. $s_{128}$ est au niveau 1 dès que le niveau du gris atteint la valeur 128. Le signal $s_{32}$ est introduit à une des deux entrées d'une porte ET 11 dont l'autre entrée reçoit un signal logique $S_0$, $S_0$ étant au niveau logique 0 lorsque la réception a lieu selon le standard MAC et au niveau logique 1 pour les systèmes PAL ou SECAM. Le signal $s_{128}$ est introduit à une des deux entrées d'une porte ET 12 dont l'autre entrée reçoit le signal logique $S_0$ inversé par un inverseur 4. Les sorties des portes ET 11 et 12 sont appliquées aux entrées d'une porte OU 13 qui délivre en sortie le signal $S_1$ de commande de la source de courant $I_1$. Lorsque $S_0 = 0$ (standard MAC), on a $S_1 = s_{128}$; et $S_1 = s_{32}$ lorsque $S_0 = 1$ (standards PAL ou SECAM). Un signal d'autorisation p1 apparait au début de chaque ligne sous forme d'une impulsion de 750 ns pour le standard MAC et de 4 microsecondes en PAL ou SECAM et est utilisé pour autoriser la commande de la source de courant I, comme on le verra par la suite.

La figure 4 illustre l'action de commande automatique de gain à partir du signal S2. Le signal $S_2$ est de préférence un signal différentiel dont les niveaux haut et bas sont distants de par exemple 200mV, de manière à attaquer les bases des transistors $T_{10}$ et $T_{11}$ constituant les entrées d'un étage différentiel (signaux $e1_0$ et $e_{11}$). Les émetteurs des transistors $T_{10}$ et $T_{11}$ sont couplés entre eux et connectés à une source de courant $I_{12}$. Le collecteur du transistor $T_{10}$ est connecté directement à une source de tension d'alimentation positive +V, alors que celui du transistor $T_{11}$ est connecté à une source de courant $I_{11}$. Par exemple pour $S_2$ au niveau haut on peut avoir des valeurs respectives de $e_{10}$ et $e_{11}$ de 2,2 et 2V, et vice versa pour $S_2$ au niveau bas. Les valeurs des sources de courant $I_{11}$ et $I_{12}$ sont choisies différentes de manière à obtenir des constantes de temps différentes pour la charge et la décharge de condensateur $C_2$.

On choisit une valeur faible pour la valeur du courant de la source $I_{11}$ de manière à obtenir une charge lente du condensateur $C_2$ par exemple avec une constante de temps $t_1$ de quelques secondes, et une valeur nettement plus élevée pour la valeur du courant de la source $I_{12}$ de manière à obtenir une décharge rapide du condensateur $C_2$ évitant toute saturation, par exemple avec une constante de temps $T_2$ de 500 microsecondes. A titre d'exemple, on peut avoir $I_{11} = 100$ nA et $I_{12} = 500$ $\mu$A, pour un condensateur $C_2$ de valeur $0,47\mu$F.

Lorsque le signal $S_2$ est au niveau logique 1, $e_{11} > e_{10}$, donc le transistor $T_{11}$ est conducteur et le transistor $T_{10}$ est bloqué. Le condensateur $C_2$ se décharge grâce à la source de courant $I_{12}$ car son courant nominal est très supérieur à celui de la source de courant $I_{11}$.

Lorsque le signal $S_2$ est au niveau logique 0, $e_{10} > e_{11}$, donc le transistor $T_{10}$ est conducteur et le transistor $T_{11}$ est bloqué. Le condensateur $C_2$ se charge lentement grâce au courant de faible valeur fourni par la source de courant $I_{11}$.

On notera à titre de variante, que l'étage différentiel constitué par les transistors $T_{10}$ et $T_{11}$ peut être remplacé par deux étages différentiels en cascade.

La figure 5 montre comment le signal $S_1$ est utilisé pour commander la source de courant $I_1$. Le signal $S_1$ est de préférence un signal différentiel dont les niveaux haut et bas sont distants de par exemple de 200 mV de manière à attaquer les bases des transistors $T_1$ et $T_2$ d'un étage différentiel. Par exemple, pour le niveau 1, les signaux $e_1$ et $e_2$ appliqués aux bases respectivement des transistors $T_1$ et $T_2$ ont pour valeur respectivement 2,5 et 2,7V et pour le niveau 0 respectivement 2,7V et 2,5V. Les émetteurs couplés des transistors $T_1$ et $T_2$ sont reliés au collecteur d'un transistor $T_4$ dont l'émetteur est à la masse et dont la base est connectée à celle d'un transistor $T_3$ monté avec lui en miroir de courant, dont l'émetteur est à la masse, dont la base et le collecteur sont interconnectés et qui reçoit l'impulsion p1 à travers une résistance $R_3$, de manière à n'autoriser une correction de niveau continu que pendant l'intervalle de temps prévu à cet effet.

Deux transistors $T_5$ et $T_6$ sont montés en miroir de courant dans les collecteurs des transistors $T_1$ et $T_2$. Leurs émetteurs sont connectés à une source de tension d'alimentation +V (par exemple 5V), leurs bases sont interconnectées et leurs collecteurs connectés respectivement à celui des transistors $T_1$ et $T_2$. En outre, la base et le collecteur du transistor $T_5$ sont connectés ensemble directement ou bien, comme représenté, à travers le trajet émetteur-base d'un transistor $T_7$ dont le collecteur est à la masse. Si celui des deux signaux sélectionnés par So, $s_{32}$ ou $s_{128}$ est au niveau 1, alors $e_2 > e_1$, et le transistor $T_2$ est conducteur alors que le transistor $T_1$ est bloqué, et on obtient une décharge du condensateur $C_1$ à travers le transistor $T_4$ fonctionnant en source de courant pendant la durée de l'impulsion p1, ce qui abaisse le niveau du courant continu à l'entrée de l'amplificateur $A_1$. Par contre, si celui des deux signaux sélectionnés $s_{32}$ ou $s_{128}$ est au niveau 0, alors $e_1 < e_2$, et le transistor $T_1$ est conducteur alors que le transistor $T_2$ est bloqué. Comme les transistors $T_5$ et $T_6$ forment un miroir de courant, le condensateur $C_1$ est chargé par le courant de même intensité que celle traversant le transistor $T_4$ et qui traverse le transistor $T_6$ pendant la durée de l'impulsion p1, ce qui remonte le niveau continu à l'entrée de l'amplificateur $A_1$.

La figure 8 donne les niveaux logiques des quatre sorties de poids fort en code GRAY du convertisseur analogique-numérique. On rappelle que le code GRAY est un code pour lequel toute incrémentation d'une unité positive ou négative d'un nombre ne fait commuter qu'un seul des bits.

Dans le cas d'espèce, le code GRAY est choisi pour sa propriété de simplifier la logique pour les niveaux logiques à traiter.

Le bit $G_5$ est au niveau 0 pour les valeurs logiques comprises entre 0 et 15, et commute au niveau 1 pour la valeur 16. Il commute de nouveau à chaque fois qu'à la valeur 16 s'ajoute un multiple de 32, la dernière commutation, un retour à zéro, ayant lieu pour la valeur 240. Le bit $G_6$ est au niveau 0 pour les valeurs logiques comprises entre 0 et 31 et commute au niveau 1 pour la valeur 32. Il commute de nouveau à chaque fois qu'à la valeur 32 s'ajoute un multiple de 64, la dernière commutation, un retour à zéro, ayant lieu pour la valeur 224. Le bit $G_7$ est au niveau 0 pour les valeurs logiques comprises entre 0 et 63 et commute au niveau 1, pour la valeur 64 et retourne au niveau 0 pour des valeurs supérieures à 192. Le bit $G_8$ est au niveau 0 pour les valeurs logiques comprises entre 0 et 127, et au niveau 1 pour les valeurs logiques comprises entre 128 et 256.

Le signal $s_{17}$ doit être au niveau 0 pour les valeurs comprises entre 0 et 15 et 240 et 256, et au niveau 1 sinon. Ce dernier cas intervient quand on a $G_5 = G_6 = G_7 = 0$. Le signal $s_{224}$ est au niveau 0 pour les valeurs comprises entre 0 et 223 et au niveau 1 pour celles comprises entre 224 et 256. Ce dernier cas intervient pour $G_6 = G_7 = 0$ et $G_8 = 1$. Le signal $s_{32}$ est au niveau 0 pour les valeurs comprises entre 0 et 31 et au niveau 1 pour celles comprises entre 32 et 256. Ce dernier cas intervient pour $G_6 = G_7 = G_8 = 0$.

Le signal $s_{128}$ enfin correspond directement à la sortie logique $G_8$.

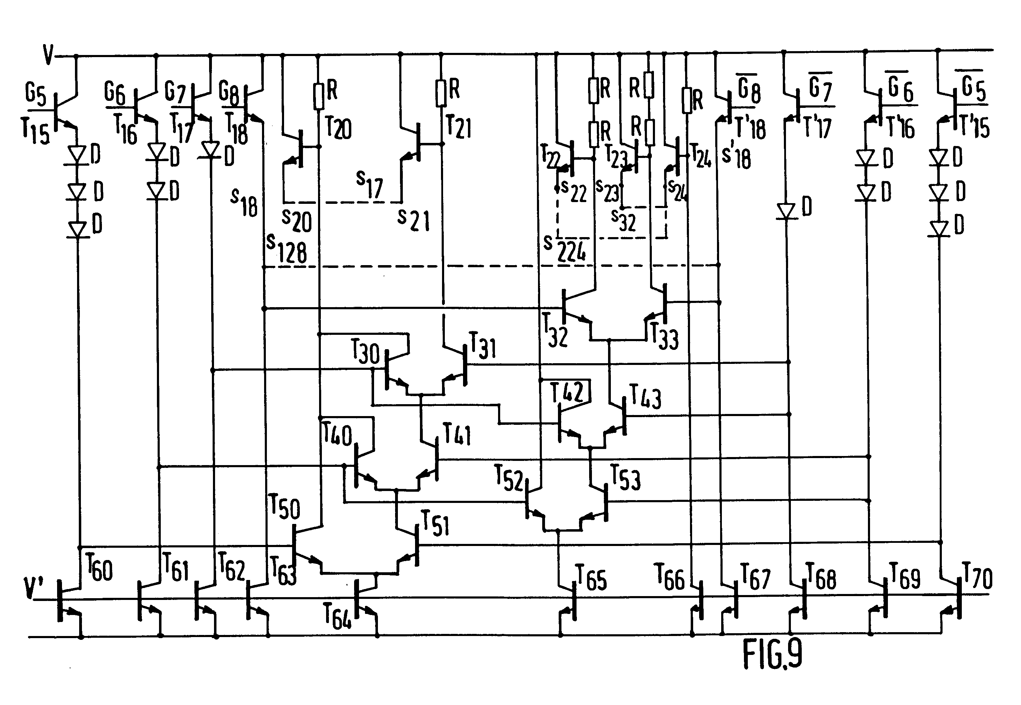

Selon la figure 9, le décodage des états recensés précédemment est réalisé à partir des sorties logiques $G_5$ à $G_8$ et leurs complémentaires disponibles sous forme de logique TTL. L'organisation générale du décodeur consiste en des paires différentielles à émetteurs couplés échelonnées en trois niveaux, avec deux paires différentielles par niveau, et aiguillant des sources de courant. Les signaux $G_5$, $G_6$, $G_7$ et $G_8$ sont appliqués à la base de transistors respectivement $T_{15}$, $T_{16}$, $T_{17}$, $T_{18}$, $T'_{15}$, $T'_{16}$, $T'_{17}$ et $T'_{18}$ dont le collecteur est connecté à une tension d'alimentation +V, de valeur 5V.

Onze transistors $T_{60}$ à $T_{70}$ forment autant de sources de courant et reçoivent chacun sur leur base une même tension de référence V', et leurs émetteurs sont connectés à la masse. Le collecteurs des transistors $T_{60}$ et $T_{70}$ est relié à l'émetteur des transistors respectivement $T_{15}$ et $T'_{15}$ à travers trois diodes de décalage de niveau disposées en série et dans le sens direct. Le collecteur des transistors $T_{61}$ et $T_{69}$ est relié à l'émetteur respectivement des transistors $T_{16}$ et $T'_{16}$ à travers deux diodes de décalage de niveau disposées en série et dans le sens direct. Le collecteur des

transistors $T_{62}$ et $T_{68}$ est relié à l'émetteur respectivement des transistors $T_{17}$ et $T'_{17}$ à travers une diode de décalage de niveau disposée dans le sens direct. Le collecteur des transistors $T_{63}$ et $T_{67}$ est connecté directement à l'émetteur respectivement des transistors $T_{18}$ et $T'_{18}$.

Les deux paires différentielles de chaque niveau sont respectivement constituées par les transistors à émetteurs couplés $T_{30}$, $T_{31}$ et $T_{32}$, $T_{33}$ pour le premier niveau, $T_{40}$, $T_{41}$ et $T_{42}$, $T_{43}$ pour le deuxième niveau et $T_{50}$, $T_{51}$ et $T_{52}$, $T_{53}$ pour le troisième niveau. Les émetteurs couplés des transistors $T_{30}$ et $T_{31}$, $T_{32}$ et $T_{33}$, $T_{40}$ et $T_{41}$, $T_{42}$ et $T_{43}$, $T_{50}$ et $T_{51}$, et $T_{52}$ et $T_{53}$ sont connectés aux collecteurs des transistors respectivement $T_{41}$, $T_{43}$ $T_{51}$, $T_{53}$, $T_{64}$ et $T_{65}$. Les collecteurs des transistors $T_{30}$, $T_{40}$ et $T_{50}$ sont interconnectés, et sont connectés à la base d'un transistor $T_{20}$, elle même reliée à la tension d'alimentation $+V$ à travers une résistance R. Le collecteur du transistor $T_{20}$ est connecté à la tension d'alimentation $+V$. Le collecteur du transistor $T_{31}$ est connecté à la base d'un transistor $T_{31}$ elle-même reliée à la tension d'alimentation $+V$ à travers une résistance R. Le collecteur du transistor $T_{31}$ est connecté à la tension d'alimentation $+V$. Les collecteurs des transistors $T_{32}$ et $T_{33}$ sont connectés à la base de transistors respectivement $T_{22}$ et $T_{23}$, elle-même reliée à la source de tension d'alimentation $+V$ à travers une résistance 2R. Les collecteurs des transistors $T_{42}$ et $T_{52}$ sont connectés à la source de tension d'alimentation $+V$.

Les collecteurs des transistors $T_{60}$ à $T_{63}$ sont connectés à la base des transistors respectivement $T_{50}$ d'une part, $T_{40}$ et $T_{52}$ d'autre part, $T_{30}$ et $T_{42}$ ensuite, et enfin $T_{32}$. Les collecteurs des transistors $T_{67}$ à $T_{70}$ sont connectés à la base des transistors respectivement $T_{33}$ d'une part, $T_{31}$ et $T_{43}$ d'autre part, $T_{41}$ et $T_{53}$ ensuite, et enfin $T_{51}$. Un transistor $T_{24}$ a sa base connectée au collecteur du transistor $T_{66}$ et reliée à la tension d'alimentation $+V$ à travers une résistance de valeur R, et son collecteur connecté à la tension d'alimentation $+V$.

Le signal $s_{17}$ est disponible entre les émetteurs des transistors $T_{20}$ et $T_{21}$. En effet, lorsque $G_5 = G_6 = G_7 = 0$, les transistors $T_{31}$, $T_{41}$ et $T_{51}$ sont conducteurs et les transistors $T_{30}$, $T_{40}$ et $T_{50}$ sont bloqués. Le signal $s_{224}$ est disponible entre les émetteurs des transistors $T_{22}$ et $T_{24}$. En effet, lorsque $G_6 = G_7 = 0$ et $G_8 = 1$, les transistors $T_{32}$, $T_{43}$ et $T_{53}$ sont conducteurs.

Le signal $s_{31}$ est disponible entre les émetteurs des transistors $T_{23}$ et $T_{24}$.

En effet lorsque $G_6 = G_7 = G_8 = 0$, les transistors $T_{37}$, $T_{43}$ et $T_{53}$ sont conducteurs.

Enfin, le signal $s_{128}$ est directement disponible entre les émetteurs des transistors $T_{18}$ et $T'_{18}$.

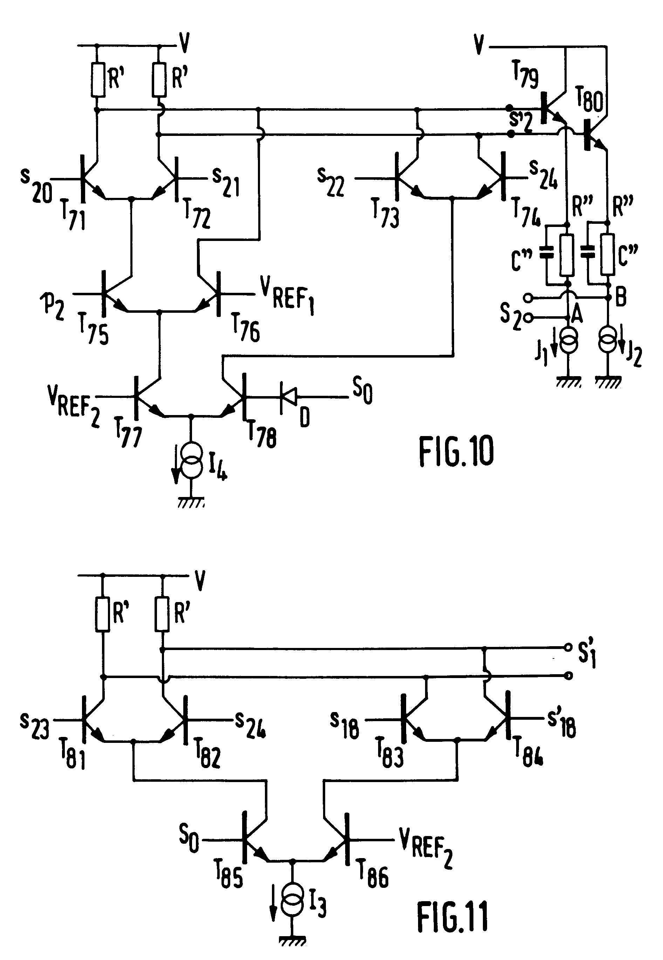

Selon la figure 10, un signal de sortie S'2 est obtenu à partir des signaux $s_{20}$, $s_{21}$, $s_{22}$, $s_{24}$, $p_2$ et $S_0$.

Deux paires différentielles, respectivement constituées des transistors $T_{71}$ et $T_{72}$, $T_{72}$ et $T_{74}$ à émetteurs couplés, recevant sur leur base les signaux respectivement $s_{20}$, $s_{21}$, $s_{22}$ et $s_{24}$ constituent un nivëau de commande. Les collecteurs des transistors $T_{71}$ et $T_{73}$ d'une part, et $T_{72}$ et $T_{74}$ d'autre part sont connectés entre eux et reliés à la tension d'alimentation $+V$ à travers une résistance R'.

Un premier niveau d'aiguillage est constitué par une paire différentielle comportant deux transistors $T_{75}$ et $T_{76}$ à émetteurs couplés recevant sur leur base respectivement le signal $p_2$ et un signal de tension de référence $V_{REF}$. Le collecteur de transistor $T_{75}$ est connecté aux émetteurs couplés des transistors $T_{75}$ et $T_{76}$, alors que le collecteur des transistor $T_{76}$ est connecté aux collecteurs interconnectés des transistors $T_{71}$ et $T_{73}$.

Un deuxième niveau d'aiguillage est constitué par une paire différentielle comportant deux transistors $T_{77}$ et $T_{78}$ à émetteurs couplés recevant sur leur base respectivement un signal de tension de référence $V_{REF}$ et le signal $S_0$ décalé d'une tension d'une diode.

Le collecteur du transistor $T_{77}$ et $T_{78}$ sont connectés respectivement aux émetteurs couplés des transistor $T_{75}$ et $T_{76}$ et des transistors $T_{73}$ et $T_{74}$. Une source de courant $I_4$ référencée à la masse est connectée aux émetteurs couplés des transistors $T_{77}$ et $T_{78}$.

Lorsque $S_0$ est au niveau haut (fonctionnement en PAL ou SECAM), le transistor $T_{71}$ est passant et la sortie $s'_2$ correspond à l'état logique du signal $s_{224}$. Lorsque $S_0$ est au niveau bas, le transistor $T_{77}$ est passant, et la sortie $S'_2$ correspond à l'état logique du signal $s_{17}$ lorsque le signal $p_2$ est au niveau 1 et rend passant le transistor $T_{75}$. Lorsque le signal $p_2$ est au niveau 0 le transistor $T_{76}$ est passant et le collecteur du transistor $T_{71}$ reste au niveau bas quelque soit l'état logique des entrées $s_{20}$ et $s_{21}$, et le signal $s'_2$ est maintenu au niveau 0, produisant une charge lente du condensateur $C_2$ par la source de courant $I_{11}$ (fig. 4).

Pour obtenir le signal $S_2$ à partir du signal $S'_2$, on introduit les signaux présents aux collecteurs des transistors $T_{71}$ et $T_{72}$ respectivement à la base des transistors $T_{79}$ et $T_{80}$ montés en suiveur, dont le collecteur est connecté à la source de tension V et l'émetteur relié à la masse à travers une résistance R'', aux bornes de laquelle est connecté un condensateur C'', et une source de courant respectivement $J_1$ et $J_2$, les points A et B désignant la borne commune aux résistances R'' et aux sources de courant $J_1$ et $J_2$ respectivement.

On utilise la réristance R' dans les collecteurs

des transistors $T_{71}$ et $T_{72}$ pour ajuster la tension différentielle de $S_2$. Par exemple, avec $R' = 1,6$ k$\Omega$ et $I_1 = 150\mu$A, on obtient une tension différentielle de 240 mV.

Soient $V_A$ et $V_B$ les tensions aux points A et B. On a :

$$V_A = V - V_{be} - R'' J_1 - R'I_1 k$$
$$V_B = V - V_{be} - R'' J_2 - R'I_1 (1-k)$$

$V_{be}$ désignant la chute de tension base-émetteur d'un transistor et k valant 0 ou 1 suivant le sens de commutation des paires différentielles.

Avec $V = 5$ volts, $R'' = 9,7$ k$\Omega$, $J_1 = J_2 = 100\mu$A, $R' = 1,6$ k$\Omega$ et $I_1 = 150\mu$A et $V_{be} \simeq 0,8$V on obtient :

pour $k = 0$ $V_A = 2,4648$V $V_b = 2,408$V
pour $k = 1$ $V_A = 2,408$V $V_b = 2,648$V.

Selon la figure 11, le signal de sortie $s'_1$ est obtenu à partir des signaux $s_{23}$, $s_{24}$, $s_{18}$, $s'_{18}$ et $S_0$.

Deux paires différentielles respectivement constituées des transistors $T_{81}$ et $T_{82}$, $T_{83}$ et $T_{84}$ à émetteurs couplés, recevant sur leur base les signaux respectivement $s_{23}$, $s_{24}$, $s_{18}$, constituent un niveau de commande. Les collecteurs des transistors $T_{81}$ et $T_{83}$ d'une part, $T_{82}$ et $T_{84}$ d'autre part, sont connectés entre eux et reliés à la tension d'alimentation $+V$ à travers une résistance $R'$.

Un niveau d'aiguillage est constitué par une paire différentielle comportant deux transistors $T_{85}$ et $T_{86}$ à émetteurs couplés recevant sur leur base respectivement le signal $S_0$ et un signal de tension de référence $V_{REF2}$. Le collecteur du transistor $T_{85}$ est connecté aux émetteurs couplés des transistors $T_{81}$ et $T_{82}$, alors que celui des transistors $T_{86}$ est connecté aux émetteurs couplé des transistors $T_{83}$ et $T_{84}$. Une source de courant $I_3$ référencée à la masse est connectée aux émetteurs couplés des transistors $T_{85}$ et $T_{86}$. Lorsque $S_0$ est au niveau haut (fonctionnement en PAL ou SECAM), le transistor $T_{85}$ est passant et la sortie $s_1$ correspond à l'état logique du signal $s_{32}$. Lorsque $S_0$ est au niveau bas (fonctionnement selon le standard MAC), le transistor $T_{86}$ est passant et la sortie $S_1$ correspondant à l'état logique du signal $s_{128}$.

Le signal $S_1$ peut être obtenu à partir du signal $S'_1$ de la même façon que le signal $S_2$ est obtenu à partir du signal $S'_2$.

## Revendications

1. Dispositif de conversion analogique-numérique comportant un dispositif de contrôle automatique de gain comprenant un amplificateur analogique à gain commandable ($A_1$) disposé en amont d'un convertisseur analogique-numérique (A/N), et une boucle de commande du gain dudit amplificateur analogique recevant des signaux de sortie du convertisseur et comportant des moyens de comparaison pour comparer par tout ou rien le niveau de sortie du convertisseur analogique-numérique avec au moins un seuil donné et des moyens de temporisation pour agir de manière temporisée sur le gain de l'amplificateur en fonction du résultat de ladite comparaison, caractérisé en ce que les moyens de comparaison comprennent au moins un décodeur numérique de niveau de sortie et en ce que les moyens de temporisation comportent une première source de courant commandable ($I_2$) agissant sur la charge et la décharge d'un premier condensateur ($C_2$) couplé à l'entrée de commande de gain dudit amplificateur, la première source ($I_2$) de courant étant commandée par la sortie des moyens de comparaison.

2. Dispositif selon la revendication 1 caractérisé en ce que ledit décodeur numérique de niveau de sortie est agencé pour décoder au moins un niveau logique correspondant au moins à un niveau de blanc d'au moins une émission de télévision.

3. Dispositif selon une des revendications 1 ou 2 caractérisé en ce que ladite source de courant commandable comporte un premier étage différentiel présentant un premier ($T_{10}$) et un deuxième ($T_{11}$) transistors dont les émetteurs sont couplés et connectés à une première source de courant de commande ($I_{12}$), le collecteur du premier transistor ($T_{10}$) étant connecté à une source de tension d'alimentation et celui du deuxième transistor ($T_{11}$) audit premier condensateur ($C_2$) ainsi qu'à une deuxième source de courant de commande ($I_{11}$), la base des premier et deuxième transistors ($T_{10}$, $T_{11}$) recevant un premier signal différentiel ($S_2$) correspondant au résultat de ladite comparaison, la deuxième source de courant ayant une valeur de courant nettement supérieure à celle de la première source de courant ($I_{11}$), de telle sorte que le premier condensateur ($C_2$), se charge avec une constante de temps donnée à travers la deuxième source de courant ($I_{11}$) pour un premier état logique du premier signal différentiel ($S_2$) et pour un deuxième état logique dudit signal ($S_2$), se décharge avec une constante de temps plus courte à travers la première source de courant ($I_{12}$).

4. Dispositif selon une des revendication précédentes caractérisé en ce que les moyens de comparaison comportent une pluralité de décodeurs numériques de niveau de sortie ($D_{16}$, $D_{240}$, $D_{224}$) sélectionnés en fonction du niveau de sortie numérique désiré.

5. Dispositif selon une des revendications précédentes caractérisé en ce qu'il comporte également des moyens pour agir de manière temporisée sur le niveau continu à l'entrée de l'amplificateur en fonction du résultat d'une comparaison fournie par au moins un décodeur de niveau continu.

6. Dispositif selon la revendication 5 caractérisé en ce que ledit niveau continu correspond à un niveau continu normalisé d'au moins une émission de télévision.

7. Dispositif selon une des revendications 5 ou 6 caractérisé en ce que le décodeur de niveau continu est numérique.

8. Dispositif selon une des revendications 5 ou 6, caractérisé en ce que lesdits moyens pour agir de manière temporisée sur le niveau continu consistent en une deuxième source de courant commandable ($I_1$) agissant sur la charge et la décharge d'un deuxième condensateur ($C_1$) connecté en série à l'entrée dudit amplificateur ($A_1$).

9. Dispositif selon la revendication 8 caractérisé en ce que la sortie du décodeur de niveau continu commande la deuxième source de courant.

10. Dispositif selon une des revendications 8 ou 9 caractérisé en ce que ladite source de courant commandable comporte un deuxième étage différentiel présentant un troisième ($T_1$) et un quatrième transistor ($T_2$) dont les émetteurs sont couplés et connectés à une troisième source de courant de commande ($T_3$, $T_4$), le collecteur du troisième transistor ($T_1$) étant connecté à celui d'un cinquième transistor ($T_5$) dont l'émetteur est connecté à ladite source de tension d'alimentation, le collecteur du quatrième transistor ($T_2$) étant connecté audit deuxième condensateur ($C_1$) ainsi qu'au collecteur d'un sixième transistor ($T_6$) dont l'émetteur est connecté à ladite source de tension d'alimentation, les bases des cinquième ($T_5$) et sixième ($T_6$) transistors étant interconnectées, la base et le collecteur du cinquième transistor ($T_5$) étant en outre court-circuités de manière à former un miroir de courant.

11. Dispositif selon une des revendications 5 à 10 caractérisé en ce qu'il comporte une pluralité de décodeurs de niveau continu sélectionnés en fonction du niveau continu désiré.

## Claims

1. An analog-to-digital converting arrangement having an automatic gain control circuit comprising an analog gain controllable amplifier ($A_1$) preceding an analog-to-digital converter (A/N), and a gain control loop of said analog amplifier receiving output signals from the converter, and comprising means for making a binary comparison between the output level of the analog-to-digital converter and at least one given threshold, and means for controlling the amplifier gain in a time-controlled manner as a function of the result of said comparison, characterized in that the comparison means comprise at least one output level digital decoder and in that the time-control means comprise a first controllable current source ($I_2$) effecting the charging and discharging of a first capacitor ($C_2$) which is coupled to the gain control input of said amplifier, the first current source ($I_2$) being controlled by the output of the comparison means.

2. An arrangement as claimed in Claim 1, characterized in that said output level digital decoder is operated to decode at least one logic level corresponding to at least one white level of at least one television transmission system.

3. An arrangement as claimed in Claim 1 or 2, characterized in that said controllable current source has a first differential stage comprising a first ($T_{10}$) and a second ($T_{11}$) transistor whose emitters are coupled together and to a first control current source ($I_{12}$), the collector of the first transistor ($T_{10}$) being coupled to a supply voltage source and that of the second transistor ($T_{11}$) being coupled to said first capacitor ($C_2$) as well as to a second control current source ($I_{11}$) the bases of the first and second transistors ($T_{10}$, $T_{11}$) receiving a first differential signal ($S_2$) corresponding to the result of said comparison, the second current source having a current value distinctly superior to that of the first current source ($I_{11}$), so that the first capacitor ($C_2$) is charged with a given time constant through the second current source ($I_{11}$) for a first logic state of the first differential signal ($S_2$) and for a second logic state of said signal ($S_2$) is discharged with a shorter time constant through the first current source ($I_{12}$).

4. An arrangement as claimed in any one of the preceding Claims, characterized in that the comparison means comprise a plurality of output level digital decoders ($D_{16}$, $D_{240}$, $D_{224}$) selected as a function of the desired digital output level.

5. An arrangement as claimed in any one of the preceding Claims, characterized in that it also comprises means for controlling in a time-controlled manner the dc level at the input of the amplifier as a function of the result of a comparison produced by at least one decoder of the dc level.

6. An arrangement as claimed in Claim 5, characterized in that said dc level corresponds to a standardized dc level of at least one television transmission system.

7. An arrangement as claim in Claims 5 or 6, characterized in that the dc level decoder is a digital decoder.

8. An arrangement as claimed in Claim 5 or 6, characterized in that said means for influencing the dc level in a time-controlled manner comprise a second controllable current source ($I_1$) effecting the charging and discharging of a second capacitor ($C_1$) which is coupled in series to the input of said amplifier ($A_1$).

9. An arrangement as claimed in Claim 8, characterized in that the output of the dc level decoder controls the second current source.

10. An arrangement as claimed in Claim 8 or 9, characterized in that said controllable current source comprises a second differential stage having a third ($T_1$) and a fourth transistor ($T_2$) whose emitters are coupled together and to a third control current source ($T_3$, $T_4$), the collector of the third transistor ($T_1$) being coupled to that of a fifth transistor ($T_5$) whose emitter is coupled to said supply voltage source, the collector of the fourth transistor ($T_2$) being coupled to said second capacitor ($C_1$) as well as to the collector of a sixth transistor ($T_6$) whose emitter is coupled to said supply voltage source, the bases of the fifth ($T_5$) and sixth ($T_6$) transistors being intercoupled, the base and the collector of the fifth transistor ($T_5$) being also short-circuited so that a current mirror is formed.

11. An arrangement as claimed in any one of Claims 5 to 10, characterized in that it comprises a plurality of dc level decoders selected as a function of the desired dc level.

**Patentansprüche**

1. Analog-Digital-Wandler mit einer Anordnung zur automatischen Verstärkungsregelung mit einem vor einem Analog-Digital-Wandler (A/N) vorgesehenen analogen Verstärker mit regelbarer Verstärkung ($A_1$), sowie mit einer Verstärkungsregelschleife des genannten analogen Verstärkers, die Ausgangssignale von dem Wandler erhält und mit Vergleichsmitteln zum Vergleichen des Ausgangspegels des Analog-Digital-Wandlers mit mindestens einer gegebenen Schwelle, und mit Verzögerungsmitteln zum verzögerten Beeinflussen der Verstärkung des Verstärkers je nach dem Ergebnis dieses Vergleichs, dadurch gekennzeichnet, daß die Vergleichsmittel mindestens einen digitalen Ausgangspegel-Decoder aufweisen, und daß die Verzögerungsmittel eine erste steuerbare Stromquelle ($I_2$) aufweisen, die das Laden bzw. Entladen eines ersten Kondensators ($C_2$) beeinflußt, der mit dem Verstärkungssteuereingang des genannten Verstärkers verbunden ist, wobei diese erste Stromquelle ($I_2$) durch das Ausgangssignal der Vergleichsmittel gesteuert wird.

2. Wandler nach Anspruch 1, dadurch gekennzeichnet, daß der genannte digitale Ausgangspegel-Decoder dazu eingerichtet ist, mindestens einen logischen Pegel zu detektieren, der mindestens einem Weißpegel mindestens einer Fernsehübertragung entspricht.

3. Wandler nach einem der Ansprüche 1 oder 2, dadurch gekennzeichnet, daß die genannte steuerbare Stromquelle eine erste Differenzstufe aufweist mit einem ersten ($T_{10}$) und einem zweiten ($T_{11}$) Transistor, deren Emitter-Elektroden miteinander gekoppelt und mit einer ersten Steuerstromquelle ($I_{12}$) verbunden sind, wobei der Kollektor des ersten Transistors ($T_{10}$) mit einer Speisespannungsquelle verbunden ist und der des zweiten Transistors ($T_{11}$) mit dem genannten ersten Kondensator ($C_2$) sowie mit einer zweiten Steuerstromquelle ($I_{11}$), wobei die Basis des ersten und des zweiten Transistors ($T_{10}$, $T_{11}$) ein erstes dem Ergebnis des genannten Vergleichs entsprechendes Differenzsignal erhalten, wobei die zweite Stromquelle einen Stromwert aufweist, der wesentlich höher ist als der der ersten Stromquelle ($I_{11}$), derart, daß der erste Kondensator ($C_2$) sich auflädt mit einer Zeitkonstanten, die durch die zweite Stromquelle ($I_{11}$) gegeben wird für einen ersten logischen Zustand des ersten Differenzsignals ($S_2$) und für einen zweiten logischen Zustand des genannten Signals ($S_2$)

sich entlädt mit einer Kürzeren Zeitkonstanten durch die erste Stromquelle ($I_{12}$).

4. Wandler nach einem der vorstehenden Ansprüche, dadurch gekennzeichnet, daß die Vergleichsmittel eine Anzahl digitaler Ausgangspegel-Decoder ($D_{16}$, $D_{240}$, $D_{224}$) aufweisen, die je nach dem erwünschten Ausgangspegel gewählt worden sind.

5. Wandler nach einem der vorstehenden Ansprüche, dadurch gekennzeichnet, daß er ebenfalls Mittel aufweist zum verzögerten Beeinflussen des Gleichstrompegels am Eingang des Verstärkers, je nach dem Ergebnis eines Vergleichs durch mindestens einen Gleichstrompegel-Decoder.

6. Wandler nach Anspruch 5, dadurch gekennzeichnet, daß der genannte Gleichstrompegel einem genormten Gleichstrompegel mindestens einer Fernsehübertragung enspricht.

7. Wandler nach einem der Ansprüche 5 oder 6, dadurch gekennzeichnet, daß der Gleichstrompegel-Decoder digital ist.

8. Wandler nach einem der Ansprüche 5 oder 6, dadurch gekennzeichnet, daß die genannten Mittel zum verzögerten Beeinflussen des Gleichstrompegels aus einer zweiten steuerbaren Stromquelle ($I_1$) bestehen, der das Laden bzw. Entladen eines zweiten Kondensators ($C_1$) beeinflußt, der mit dem Eingang des genannten Verstärkers ($A_1$) in Reihe geschaltet ist.

9. Wandler nach Anspruch 8, dadurch gekennzeichnet, daß das Ausgangssignal des Gleichstrompegel-Decoders die zweite Stromquelle steuert.

10. Wandler nach einem der Ansprüche 8 oder 9, dadurch gekennzeichnet, daß die genannte steuerbare Stromquelle eine zweite Differenzstufe aufweist, die einen dritten ($T_1$) und einen vierten ($T_2$) Transistor aufweist, deren Emitter-Elektroden miteinander gekoppelt und mit einer dritten Steuerstromquelle ($T_3$, $T_4$) verbunden sind, wobei der Kollektor des dritten Transistors ($T_1$) mit dem eines fünften Transistors ($T_5$) verbunden ist, dessen Emitter mit der genannten Speisespannungsquelle verbunden ist, wobei der Kollektor des vierten Transistors ($T_2$) mit dem genannten zweiten Kondensator ($C_1$) verbunden ist, sowie mit dem Kollektor eines sechsten Transistors ($T_6$), dessen Emitter mit der genannten Speisespannungsquelle verbunden ist, wobei die Basis-Elektroden des fünften ($T_5$) und sechsten ($T_6$) Transistors miteinander verbunden sind, während die Basis und der Kollektor des fünften Transistors ($T_5$) außerdem derart kurzgeschlossen sind, daß ein Stromspiegel gebildet wird.

11. Wandler nach einem der Ansprüche 5 bis 10, dadurch gekennzeichnet, daß er eine Anzahl Gleichstrompegel-Decoder aufweist, die je nach dem erwünschten Gleichstrompegel gewahält worden sind.

FIG.1

FIG.2

FIG.3

FIG.4

FIG.5

12

FIG.6

FIG.7a

FIG.7b

FIG.8

FIG.9

FIG.10

FIG.11